# EUROPÄISCHE PATENTSCHRIFT

(11) **EP 2 126 982 B1**
(45) Veröffentlichungstag und Bekanntmachung des Hinweises auf die Patenterteilung: **29.08.2018**
(21) Anmeldenummer: 08715444.9
(22) Anmeldetag: 30.01.2008
(51) Int. Cl.: H01L 33/50, H01L 25/075

(54) **ANORDNUNG UND VERFAHREN ZUR ERZEUGUNG VON MISCHLICHT**
ASSEMBLY AND METHOD FOR GENERATING MIXED LIGHT
ENSEMBLE ET PROCÉDÉ POUR GÉNÉRER DE LA LUMIÈRE MIXTE

(30) Priorität: 02.02.2007 DE 102007005343; 02.03.2007 DE 102007010244
(43) Veröffentlichungstag der Anmeldung: 02.12.2009
(73) Patentinhaber: OSRAM Opto Semiconductors GmbH, 93055 Regensburg (DE)
(72) Erfinder: GRÖTSCH, Stefan, 93077 Lengfeld-Bad Abbach (DE); BOGNER, Georg, 93138 Lappersdorf (DE); HAHN, Berthold, 93155 Hemau (DE); HÄRLE, Volker, 93164 Laaber (DE); PETERSEN, Kirstin, 93059 Regensburg (DE)
(74) Vertreter: Epping - Hermann - Fischer
(86) Internationale Anmeldenummer: PCT/DE2008/000167
(87) Internationale Veröffentlichungsnummer: WO 2008/092437

(56) Entgegenhaltungen:
- WO-A-2004/030109
- WO-A-2004/068597
- WO-A-2004/097949
- WO-A-2006/035388
- DE-A1-102005 020 695
- DE-C1- 19 845 229
- US-A1- 2004 217 364
- US-A1- 2007 018 182

## Beschreibung

Die Erfindung bezieht sich auf eine Anordnung bzw. ein Verfahrenen zur Erzeugung eines Mischlichtes mit mehreren Halbleiterbauelementen.

In der Bildwiedergabe- bzw. Projektionstechnik werden Mischlichtquellen, d.h. Quellen, beispielsweise Weißlichtquellen, für elektromagnetische Strahlung unterschiedlicher Wellenlängen, als Lichtquellen unter anderem als Hintergrundbeleuchtung benutzt. Als Einsatzgebiet sei hier die LCD-Projektions- und -bildwiedergabetechnik beispielhaft erwähnt. Hier dient dieses Mischlicht zur Aufhellung der im Bildwiedergabesystem bzw. Projektionssystem befindlichen Flüssigkristallmatrix. Diese Matrix besitzt eine Vielzahl einzelner Flüssigkristalle. Diese Kristalle werden, abhängig von einer angelegte Steuerspannung und der die Kristalle passierenden Wellenlänge des Lichtes, transparent. Diese Flüssigkristallmatrix wird allgemein als Lichtmodulator bezeichnet. Durch Aufhellung des Lichtmodulators mit einem Mischlicht wird das durch Ansteuerung generierte Bild sichtbar und erhält einen wahrnehmbaren Kontrast.

Als Lichtmodulator ist weiterhin auch der Einsatz von Digital Light Processing (DLP) - Technik denkbar. Hierbei werden mikroskopisch kleine Spiegel (digital micromirror devices, DMD) verwendet, welche auf einem DMD-Chip aufgebracht sind. Diese Spiegel sind beweglich und besitzen zwei stabile Endzustände, zwischen denen durch die Kraftwirkung elektrostatischer Felder binnen weniger Mikrosekunden gewechselt werden kann. Durch die Neigung der einzelnen Mikrospiegel auf dem DMD-Chip wird Licht entweder direkt zur Optik reflektiert oder zu einem Absorber geleitet. Durch pulsweitenmodulierte Ansteuerung der Spiegel können verschiedene Helligkeitsstufen der einzelnen Bildpunkte erzeugt werden. Anders als in der LCD- Technik arbeiten hier die Spiegel wellenlängenunabhängig. Zur Erzeugung eines Farbbildes werden die sogenannten Primärfarben rot, grün und blau sequentiell auf den DMD-Chip geschalten. Die Stellung der Spiegel bestimmt den Farbanteil im Bild. Aufgrund des direkteren Lichtweges im Vergleich zur LCD-Technik und der fehlenden Polarisierung des Lichts werden höhere Ausgangslichtleistungen erreicht als bei einem LCD-Projektor.

Bislang wurde halbleitergeneriertes Mischlicht durch die Zusammenführung so genannter Primärfarben erzeugt. Diese Primärfarben sind durch ein emittierendes Halbleiterbauelement, z.B. LED erzeugte elektromagnetische Strahlung der Farben Rot, Grün und Blau. Durch Überlagerung dieser drei Farben entsteht so genanntes Mischlicht. Es besitzt eine Vielzahl von unterschiedlichen Wellenlängen im sichtbaren Bereich, zum Beispiel im Bereich von 380nm bis 780nm.

Zur Erzeugung dieser unterschiedlichen Wellenlängen werden die aktiven Schichten des PN- Überganges der Halbleiterbauelemente beispielsweise unterschiedlich dotiert. Die dadurch entstehenden unterschiedlichen Energieniveaudifferenzen der Energieniveauschemata, auch als Bandlücken bezeichnet, führen zu einer Emission von Licht unterschiedlicher Wellenlänge. Die Wellenlänge dieses Lichtes ist direkt abhängig vom Energieniveauunterschied und mittels der Dotierung bedingt einstellbar.

Einen bedeutenden Anteil am so erzeugten Mischlicht hat dabei die Farbe Grün, da das menschliche Auge mit seinen spektralen Absorptionseigenschaften für die Farbe Grün am empfindlichsten ist. Dementsprechend ist es speziell bei Bildwiedergabesystemen erforderlich, die Farbe Grün so authentisch und stabil wie möglich zu erzeugen.

Die Halbleiterbauelemente, speziell zur Verwendung in Projektionssystemen, werden mit einer hohen Stromdichte betrieben. Hierdurch werden eine hohe Strahlungsflussdichte bzw. eine hohe Strahlstärke erreicht. Diese hohe Stromdichte verursacht bei der herkömmlich hergestellten LED einen Effekt, der in der Technik als Wellenlängendrift bekannt ist.

Durch die höhere Stromdichte ändert sich die emittierte Primärwellenlänge des Halbleiterbauelementes. Insbesondere die herkömmlichen grün-emittierenden InGaN-LED besitzen eine hohe Abhängigkeit der emittierten Wellenlänge vom Betriebsstrom. Bei Erhöhung dieses Stromes verschiebt sich die Betriebswellenlänge, die vorzugsweise zwischen 520nm - 560nm liegt, hin zu kürzeren Wellenlängen, was als "Drift" bezeichnet wird. Somit wird beispielsweise ein grün-emittierendes InGaN-Halbleiterbauelement bei Betrieb mit hoher Stromdichte bläulich leuchten.

Dieser Effekt hat zwei wesentliche Nachteile. Zum einen ändert sich für eine mit hoher Stromdichte betriebene Mischlichtquelle die erwünschte Wellenlänge. Für die beispielhaft erwähnte Weißlichtquelle wird der Wellenlängendrift eine bläulich scheinende Lichtquelle hervorrufen. Durch die hohe Abhängigkeit des menschlichen Auges hinsichtlich der Farbe grün entsteht nun ein subjektiver Farbeindruck. Die bereits erwähnte Ansteuerung eines Lichtmodulators in Projektionssystemen wird dahingehend verändert, dass der spektrale Abstand zwischen grün- und blau-emittiernden Halbleiterbauelementen verkleinert wird und die Trennung beider Farben auch über Zuhilfenahme dielektrischer wellenlängenselektiver Kanten- bzw. Bandpassfilter oder -spiegel im Lichtmodulator erschwert und kostenintensiviert wird.

Ein weiterer entscheidender Nachteil bei Wellenlängendrift ist eine deutlich schlechtere Energieeffizienz und ein damit verbundender schlechterer Wirkungsgrad.

Dokument US2004/0217364 A1 offenbart eine Anordnung zur Erzeugung von Mischlicht, wobei mindestens zwei, in unterschiedlichen Wellenlängenbereichen elektromagnetische Strahlung aussendende Halbleiterbauelemente als Lichtquelle verwendet werden,wobei die Halbleiterbauelemente jeweils einen Halbleiterchip aufweisen, die zur Emission von Primärwellenlänge befähigt sind und in einem Bauteilgehäuse innerhalb eines Volumenvergusses angeordnet sind,wobei mindestens eines der Halbleiterbauelemente ein Lumineszenzkonversionselement im Strahlengang aufweist, wobei das Lumineszenzkonversionselement die Primärwellenlänge in eine Sekundärwellenlänge zumindest teilweise konvertiert,wobei das Lumineszenzkonversionselement in einem Volumenverguss mit dem Halbleiterchip des Halbleiterbauelementes gefertigt wird.

Aufgabe der hier vorliegenden Erfindung ist die Erzeugung eines Mischlichtes, welches auch bei hoher Stromdichte ein sehr stabiles und konstantes Wellenlängenspektrum aufweist. Diese Aufgabe wird in den nebengeordneten Patentansprüchen angegebenen Maßnahmen gelöst.
Zur Erzeugung eines Mischlichtes ist erfindungsgemäß eine Anordnung gemäß Anspruch 1 und ein Verfahren gemäß Anspruch 12 Weitere vorteilhafte Ausgestaltungen der Erfindung sind in den untergeordneten Ansprüchen angegeben.
Zur Erzeugung eines Mischlichtes bestimmter Wellenlängen werden eine Anordnung und ein Verfahren beschrieben, welche mit

Hilfe von Halbleiterbauelementen realisiert werden, wobei mindestens ein Halbleiterbauelement ein Lumineszenzkonversionselement aufweist und dieses Halbleiterbauelement eine Primärwellenlänge aussendet, die sich im kurzwelligen unsichtbaren beziehungsweise kurzwelligen sichtbaren Bereich befindet. Vorteilhaft ist dabei die Tatsache, dass sich im nahen ultravioletten sowie im unteren sichtbaren Wellenlängenbereich sehr stabil emittierende Halbleiterbauelemente realisieren lassen, die zudem eine große Unabhängigkeit gegenüber der Betriebsstromdichte und eine hohe Energieeffizienz aufweisen.

Weiterhin ist vorgesehen, dass das Lumineszenzkonversionselement eine Sekundärwellenlänge im sichtbaren Bereich erzeugt. Entscheidend und vorteilhaft hierbei ist der Erhalt eines für das menschliche Auge sichtbaren und wellenlängenstabilen Mischlichtes. Die Stabilisierung der Wellenlänge für grünes Licht erzeugt auch bei hoher Stromdichtebelastung, einen stabilen Farbeindruck für den Menschen.

Die Konversion eines Halbleiterbauelementes zu grünem Licht ist beispielsweise unter Verwendung eines Lumineszenzkonversionselements auf Oxinitrid- und Silikatbasis möglich. Als Primärstrahler ist die Benutzung eines ultraviolettemittierenden Halbleiterbauelementes möglich. Durch Konversion dieses im unsichtbaren Wellenlängenbereich ausstrahlenden Halbleiterbauelementes wird nun beispielsweise ein grün-emittierendes Halbleiterbauelement.

Beispielhaft für den Einsatz eines Mischlichtes ist das Weißlicht erwähnt. Da die Beleuchtungseinrichtungen in Bildwiedergabe- bzw. Projektionssystemen zur Aufhellung und Kontrastbildung des eigentlich darzustellenden Bildes dienen, ist die nach diesem Anspruch beschriebene Anordnung vorteilhaft gegenüber einer herkömmlichen Anordnung. Auch bei hoher Stromdichtebelastung werden so angeordnete und beschriebene Halbleiterbauelemente ein sehr konstantes Weißlicht hinsichtlich Wellenlängenstabilität erzeugen und die unerwünschten Wellenlängendrifts ausbleiben. Ein subjektiver Farbeindruck, speziell der Verschiebung des Weißlichtes in ein bläulich wirkendes helles Licht wird somit verhindert.

Durch die Verwendung eines Lumineszenzkonversionselement auf Oxinitrid- und Silikatbasis oder anderer grün lumineszierender Materialien, die durch UV-Strahlung angeregt werden können ist beispielsweise die Konversion eines Halbleiterbauelementes hin zum grünen Licht möglich. Die durch die Eigenschaften des menschlichen Auges hervorgerufenen Farbeindrücke lassen sich mit Hilfe dieses Konversionsmittels stabil halten.

In einer weiteren Ausgestaltung wird das Lumineszenzkonversionselement in den Strahlengang des Halbleiterbauelementes eingebracht. Als Verwendung dient ein Volumenverguss. Diese Anordnung weist eine sehr kostengünstige und effektive Fertigungsvariante auf. Eine Steigerung der Kostenersparnisse und Minimierung des Fertigungsaufwandes lässt sich durch Beschichtung bzw. Abdeckung des Volumenvergusses mit dem Konversionsmaterial erzielen.

Durch minimale Absorption und maximale Reflexion der ausgesendeten Primärwellenlänge des Halbleiterchips am Halbleiterchipmaterial selbst, wird die für die Konversion bereitgestellte Strahlstärke intensiviert und hinsichtlich der Energieausbeute weiter optimiert. Ebenfalls vorteilhaft ist ein für die erhaltene Sekundärwellenlänge maximal reflektierender Halbleiterchip, um eine weitere Energieeffizienzsteigerung zu erhalten. Zu diesem Zweck wird ein spiegelndes Element in Form einer Spiegelschicht über dem Volumenverguss angebracht.

Nachfolgend wird die Erfindung anhand von Ausführungsbeispielen mit Bezugnahme auf die Zeichnung erläutert, wobei die Figuren gleiche oder gleich wirkende Bestandteile jeweils mit den gleichen Bezugszeichen gezeichnet sind. Die dargestellten Elemente sind nicht als maßstabsgerecht anzusehen, vielmehr können einzelne Elemente zum besseren Verständnis übertrieben groß beziehungsweise übertrieben vereinfacht dargestellt sein. Es zeigen:
Figur 1 Schematische Darstellung eines Projektionssystems
Figur 2 Beleuchtungseinrichtung eines Bildwiedergabesystems
Figur 3 Ausführungsbeispiel einer Leuchtdiode zur Erzeugung und Konversion elektromagnetischer Strahlung.
Figur 4 Weiteres Ausführungsbeispiel einer Leuchtdiode zur Erzeugung und Konversion elektromagnetischer Strahlung
Figur 5a Weiteres Ausführungsbeispiel einer Leuchtdiode zur Erzeugung und Konversion elektromagnetischer Strahlung
Figur 5b Weiteres Ausführungsbeispiel einer Leuchtdiode zur Erzeugung und Konversion elektromagnetischer Strahlung
Figur 6 Weiteres Ausführungsbeispiel einer Leuchtdiode zur Erzeugung und Konversion elektromagnetischer Strahlung
Figur 7a Schematische Darstellung eines Querschnitts einer LED Lichtquelle zur Erzeugung und Konversion elektromagnetischer Strahlung
Figur 7b Schematische Darstellung einer Aufsicht einer LED Lichtquelle zur Erzeugung und Konversion elektromagnetischer Strahlung

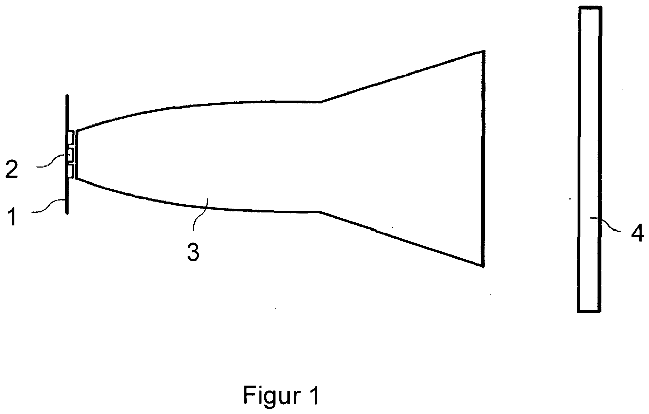

Die Figur 1 zeigt eine schematische Darstellung eines Projektionssystems, wie sie beispielweise in Projektionsgeräten, also Beamern oder in Rückprojektionsgeräten, auch rear projection television (RPTV) genannt, eingesetzt werden.

Es ist eine Beleuchtungseinrichtung 1 vorgegeben, die ein Mischlicht aus Licht mit verschiedenen Wellenlängen erzeugt. Da das erzeugte Licht der Beleuchtung dient, liegt zumindest ein Anteil im sichtbaren Bereich. Es ist jedoch nicht notwendig, dass das gesamte Licht des sogenannten gemischten Lichtes im sichtbaren Bereich liegt. Die Beleuchtungseinrichtung 1 besitzt drei Mischlichtstrahler 2, die jeweils ein Mischlicht abstrahlen. Das erzeugte Mischlicht wird über ein optisches Element 3 an einen Lichtmodulator 4 abgelenkt. Der Lichtmodulator 4 ist beispielsweise eine Flüssigkristallmatrix, die auch als LC- Matrix bezeichnet wird. Eine vorgegebene Fläche des Lichtmodulators 4 wird durch das optische Element 3 mit dem von der Beleuchtungseinrichtung 1 emittierten Licht gleichmäßig ausgeleuchtet.

Als Lichtmodulator 4 ist, wie eingangs erwähnt, ebenso ein DMD-Chip denkbar. Die Beleuchtungseinrichtung 1 erzeugt dann allerdings kein Mischlicht, sondern die Primärfarben werden getrennt voneinander ausgesendet. Dadurch wird die nötige wellenlängenabhängige sequentielle Ansteuerung des DMD-Chips ermöglicht, um ein Farbbild zu erhalten.

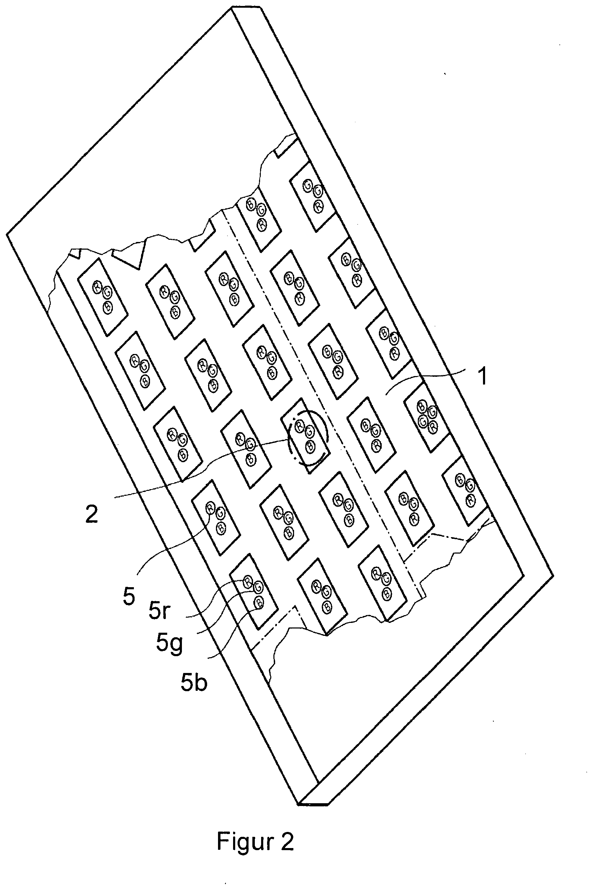

In Figur 2 wird die Beleuchtungseinrichtung 1 einer LCD- Hintergrundbeleuchtung dargestellt. Die einzelnen Mischlichtstrahler 2 sind hier in einer deutlich höheren Anzahl aufgezeigt. Es ist eine flächige Anordnung vorgesehen, in der die Mischlichtstrahler 2 in mehreren Reihen angeordnet sind. Die Reihen mit den Mischlichtstrahlern 2 sind um einen halben Abstand versetzt, um eine gleichmäßige Beleuchtung des optischen Elements 3 zu gewährleisten. Darüber hinaus sind auch andere Anordnungsvarianten denkbar. Jeder der Mischlichtstrahler 2 setzt sich hier aus drei einzelnen Leuchtdioden 5 zusammen. Das Mischlicht wird beispielsweise über die Primärfarben Rot, Grün und Blau erzeugt, wobei jede Leuchtdiode 5 vorrangig eine Primärfarbe emittiert. Die Leuchtdiode 5r emittiert dabei im Wesentlichen die Farbe Rot, wobei Rot die Farbe des Lichtes ist, welches eine Wellenlänge von 615nm - 740nm besitzt. Weiterhin emittiert die Leuchtdiode 5b im Wesentlichen die Farbe Blau, wobei Blau die Farbe des Lichtes ist, welches eine Wellenlänge von 430nm - 500nm besitzt. Schließlich emittiert die Leuchtdiode 5g die Farbe Grün, wobei Grün die Farbe des Lichtes ist, welches eine Wellenlänge von 510nm - 565nm besitzt. Das Ausführungsbeispiel ist mit den Farben Rot, Grün und Blau in Anlehnung an das herkömmliche RGB- Modell gewählt. Eine Beleuchtungseinrichtung 1, wie in Figur 2 dargestellt wird auch als "backlight" bezeichnet und befindet sich beispielsweise in Flüssigkristallanzeigegeräten oder Flüssigkristallprojektoren. Das Mischlicht muss dabei nicht zwingend aus drei LEDs erzeugt werden. Obwohl die einzelnen LEDs vorzugsweise rot, grün oder blau emittieren, sind Anordnungen von bis zu sechs Primärfarbenstrahlern denkbar. Das optische Element 3 dient hier zur homogenen Verteilung des ausgesendeten Mischlichtes auf die vorgegebene Fläche des Lichtmodulators 4.

In einem weiteren Ausführungsbeispiel werden die die Primärfarben aussendenden Leuchtdioden 5 in einer regelmäßigen Matrix angeordnet und direkt als Projektionsfläche benutzt. Diese Anordnung wird als LED- Displaywand bezeichnet. Die Leuchtdioden 5 werden in diesem Fall als Subbildpunkt bezeichnet, wobei eine Kombination aus einer Rot-, einer Grün- und einer Blau-Emittierenden Leuchtdiode als Bildpunkt definiert ist. Über ein Ansteuersignal werden die unterschiedlichen Primärfarbstrahler so angesteuert, dass das zu projizierende oder darzustellende Bild entsteht.

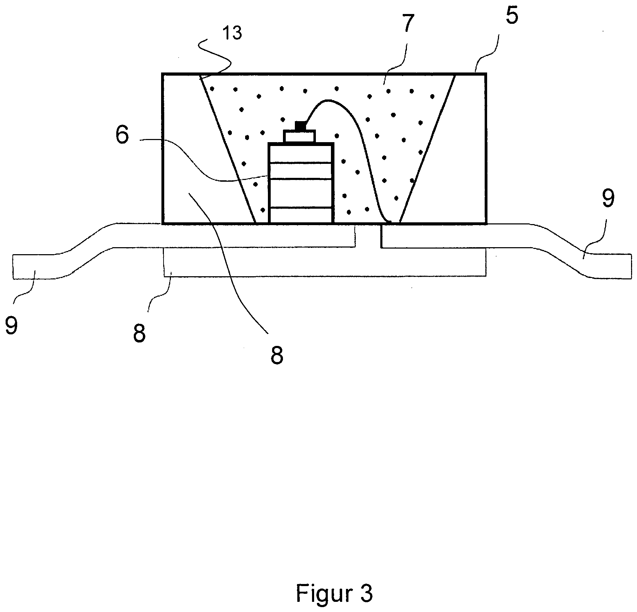

In Figur 3 wird ein schematischer Aufbau einer Leuchtdiode 5 vorgestellt. Die Leuchtdiode weist hier ein Bauteilgehäuse 13 auf. Über die elektrischen Anschlußdrähte 9, welche in das Innere des Gehäuses führen wird ein elektrischer Strom zugeführt. Innerhalb des Bauteilgehäuses 8 befindet sich ein Volumenverguss 13, der einen Halbleiterchip 6 und ein Lumineszenzkonversionselement 7 umschließt. Der in dem Volumenverguss 13 befindliche Halbleiterchip 6 wird über den zugeführten Strom angeregt und emittiert elektromagnetische Strahlung, vorrangig einer bestimmten Wellenlänge. Im Unterschied zu einer herkömmlichen Leuchtdiode ist in diesem Ausführungsbeispiel das Lumineszenzkonversionselement 7 in den Strahlengang des Licht aussendenden Halbleiterchips 6 eingebracht. Durch das Konversionselement 7 wird die primär erzeugte Wellenlänge in eine Sekundärwellenlänge umgesetzt. Beispielhaft angeführt ist hier eine Anordnung, in der der Halbleiterchip 6 und das entsprechende Konversionsmaterial 7 in einem gemeinsamen Volumenverguss 13 gefertigt sind. Zur Verbesserung der Konversion der Primärwellenlänge wird beispielsweise das Material des Halbleiterchips 6 derart ausgestalten, dass die Primärwellenlänge maximal reflektiert und minimal absorbiert wird. Gleiches gilt für das Material des Halbleiterchips 6 die Sekundärwellenlänge betreffend. Das Material des Volumenverguss 13 ist beispielsweise so gewählt, dass die Primärwellenlänge minimal reflektiert und minimal absorbiert wird. Das Material des Lumineszenzkonversionselements 7 im Volumenverguss 13 hingegen ist beispielsweise so gewählt, dass die Primärwellenlänge minimal reflektiert und maximal absorbiert wird.

Unter dem Gesichtspunkt der Wellenlängenstabilität und der maximal möglichen Lichtausbeute zeigen vor allem konvertierte Leuchtdioden bei hoher Stromdichte eine deutlich geringere Farbverschiebung im Vergleich zu herkömmlichen Leuchtdioden. Auch auftretende Effizienzverluste bei Farbüberlagerung, wenn die unterschiedlichen Primärfarben zusätzlich über so genannte Dichroitfilter auf den Lichtmodulator 4 abgebildet werden, sind deutlich geringer.

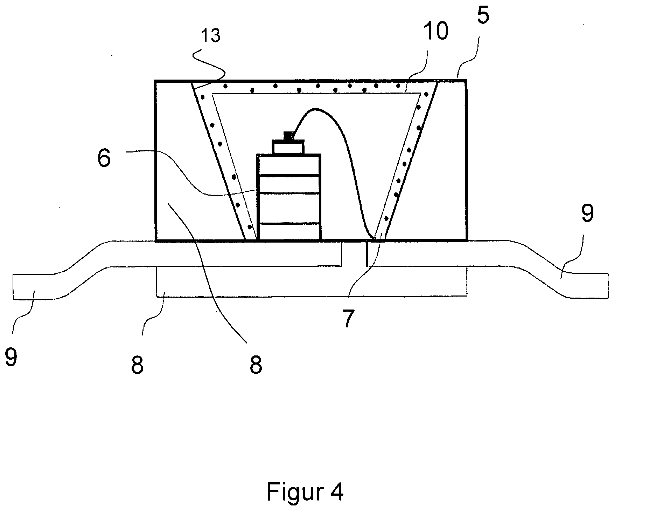

In Figur 4 wird ein weiteres Ausführungsbeispiel einer Leuchtdiode 5 angegeben. Das Ausführungsbeispiel unterscheidet sich von Figur 3 lediglich in einer Beschichtung 10 des Volumenvergusses 13 mit dem Lumineszenzkonversionselement 7. Dadurch kann die Fertigung weniger aufwendig und kostengünstiger durchgeführt werden oder eine Effizienzsteigerung erreicht werden. In Fig. 4 erhöht eine für die emittierte Primärwellenlänge spiegelnde Beschichtung zwischen Lumineszenzkonversionselement 7 und Bauteilgehäuse 8 die Energieeffizienz.

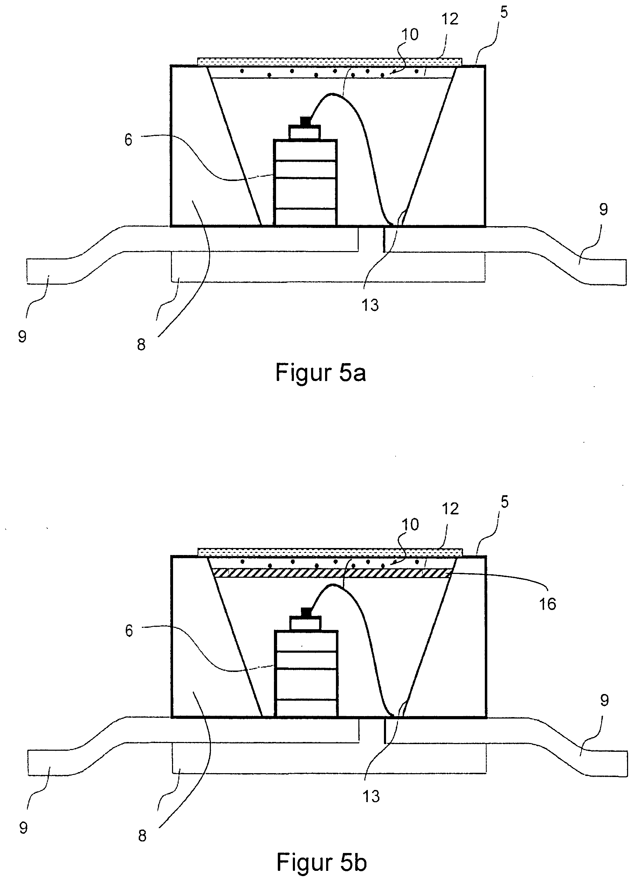

In Figur 5a wird ein weiteres Ausführungsbeispiel der Erfindung aufgezeigt. Im Unterschied zu Figur 4 wird das Lumineszenzkonversionselement 7 nicht in Form einer Beschichtung des Volumenvergusses 13 in den Strahlengang das Halbleiterchips 6 eingebracht, sondern am oberen Rand des Bauteilgehäuses 13 innerhalb des Volumenvergusses 13 platziert. Dieses derartige Einbringen kann als Abdeckung mit Konversionselement 11 bezeichnet werden. Durch diese Art der Einbringung lassen sich prozesstechnische Fertigungsschritte enorm vereinfachen.

In Figur 5b wird ein weiteres Ausführungsbeispiel der Erfindung aufgezeigt. Im Unterschied zu Figur 5a umfasst dieses Ausführungsbeispiel zusätzlich noch einen Filter 16, welcher unterhalb der Abdeckung mit dem Konversionselement 11 angeordnet ist, das hat zur Folge, dass die vom Halbleiterchip 6 abgegebene Strahlung mit der Primärwellenlänge zuerst den Filter 16 passieren muss um das Lumineszenzkonversionselement 7 zu erreichen. Das Material des Filters 16 ist beispielsweise so gewählt, dass der Filter 16 für die Strahlung mit der Primärwellenlänge durchlässig ist, wohingegen die konvertierte Sekundärwellenlänge reflektiert wird. Ist beispielsweise der Filter 16 direkt unterhalb der Abdeckung mit Konversionselement 11 angeordnet, so kann die konvertierte Sekundärwellenlänge die Abdeckung mit Konversionselement 11 nur Richtung spiegelndes Element 12 verlassen, wodurch die Effizient gesteigert wird.

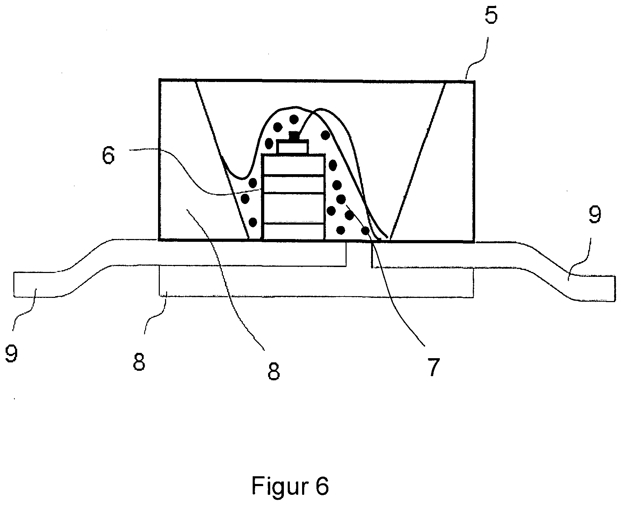

In einem weiteren Ausführungsbeispiel einer Leuchtdiode 5, dargestellt in Figur 6, wird im Unterschied zu den vorangegangenen Ausführungsbeispielen, das Lumineszenzkonversionselement 7 direkt in Nähe des Halbleiterchips 6 platziert. In einer vorteilhaften Ausführung wird der Halbleiterchip 6 direkt mit dem Lumineszenzkonversionselement 7 beschichtet. Diese Art der Ausführung wird als Chip Level Conversion (CLC) bezeichnet. In einer nicht dargestellten Variante wird das Lumineszenzkonversionselement innerhalb des Bauteilgehäuses 8 oberhalb des Halbleiterchips 6 flächig platziert. Dadurch können Punktlichtquellen für Linsenanwendungen realisiert werden. Ebenfalls sind in diesen Ausführungsvarianten spiegelnde Elemente 12 in Form einer Spiegelschicht vorgesehen, um Lichtverluste zu minimieren.

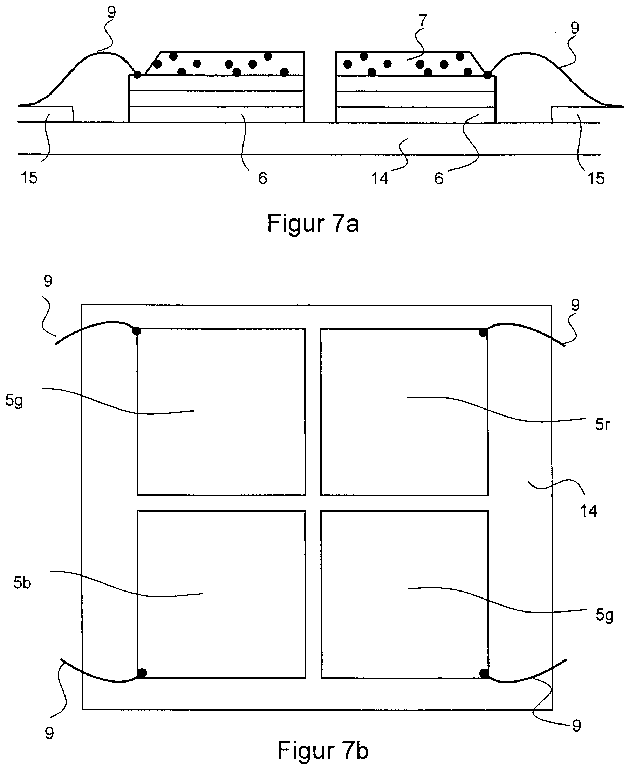

In den Figuren 7a und 7b werden jeweils eine LED Lichtquelle aufgezeigt, die in Form eines Chiparrays realisiert ist.
In Figur 7a wird ein Querschnitt eines solchen Arrays aufgezeigt. Eine gemeinsame Grundfläche dient als Gehäuseunterteil und gemeinsame Wärmesenke für mehrere Halbleiterchips 6. Diese Halbleiterchips sind beispielsweise in 2 Reihen a 2 Halbleiterchips 6 auf dieser Wärmesenke 14 platziert. Wie in Figur 6 ausgeführt, wird mittels CLC Technologie das Lumineszenzkonversionselement 7 in den Strahlengang des Halbleiterchips 6 eingebracht. Der zum Betrieb notwendige elektrische Strom wird mittels elektrischer Anschlußdrähte 9 zu den Halbleiterchips 6 geführt.
In Figur 7b wird eine Aufsicht dieser LED Lichtquelle gezeigt. In dieser beispielhaften Anordnung ist eine RGB Variante realisiert mit zwei grünemittierenden LEDs 5g einer rotemittierenden LED 5r sowie einer blauemittierenden LED 5b. Denkbar sind auch monochrome Lichtquellen, die beispielsweise nur grünes Licht emittieren. Zur Erzeugung der Farbe Grün wird beispielhaft die Leuchtdiode 5g derart ausgestaltet, dass ein Konversionsmaterial 7 auf Oxinitrid- und Silikatbasis verwendet wird. Als Primärstrahler wird eine ultraviolette Leuchtdiode verwendet. Mit einer Farbsättigung von 70 - 90% erreichen ultraviolette Primärstrahler eine höhere Strahlstärke als die herkömmlichen grün emittierenden und bisher verwendeten InGaN - LEDs. Die Anordnung auf einer gemeinsamen Wärmesenke 14 hat den Vorteil der besseren Wärmeableitung und somit einer konstanteren Temperatur, was dem Wellenlängendrift und dem Effizienzverlust positiv entgegenwirkt.

Die beschriebene Anordnung bzw. das Verfahren betrifft mindestens zwei, elektromagnetische Strahlung aussendende Halbleiterbauelemente, deren aussendende elektromagnetische Strahlung sich in unterschiedlichen Wellenlängenbereichen befindet. Die Überlagerung dieser elektromagnetischen Strahlungen aller Halbleiterbauelemente besitzt dabei zumindest einen Anteil im sichtbaren Wellenlängenbereich. Dabei weist mindestens eines der Halbleiterbauelemente ein Lumineszenzkonversionselement im Strahlengang auf. Dieses Halbleiterbauelement besitzt einen Volumenverguss, der sowohl den Halbleiterchip als auch das Lumineszenzkonversionselement vereint. In vorteilhafter Weise ist der Halbleiterchip direkt mit einer Lumineszenzkonversionsschicht beschichtet bzw. abgedeckt. Zur Maximierung der Energieeffizienz weist das Halbleiterbauelement ein spiegelndes Element auf.

### Bezugszeichenliste

- 1: Beleuchtungseinrichtung
- 2: Mischlichtstrahler
- 3: Optisches Element
- 4: Lichtmodulator
- 5: Halbleiterbauelement, Leuchtdiode
- 5r: Halbleiterbauelement, Leuchtdiode Farbkomponente rot
- 5b: Halbleiterbauelement, Leuchtdiode Farbkomponente blau
- 5g: Halbleiterbauelement, Leuchtdiode Farbkomponente grün
- 6: Halbleiterchip
- 7: Lumineszenzkonversionselement
- 8: Bauteilgehäuse
- 9: Elektrische Anschlussdrähte
- 10: Beschichtung
- 11: Abdeckung mit Lumineszenzkonversionselement
- 12: Spiegelndes Element
- 13: Volumenverguss
- 14: Wärmesenke
- 15: Isolation
- 16: Filter

## Patentansprüche

1. Eine Anordnung zur Erzeugung von Mischlicht (2), wobei mindestens zwei, in unterschiedlichen Wellenlängenbereichen elektromagnetische Strahlung aussendende Halbleiterbauelemente (5) als Lichtquelle verwendet werden,
wobei die Halbleiterbauelemente (5) jeweils einen Halbleiterchip (6) aufweisen, die zur Emission von Primärwellenlänge befähigt sind und in einem Bauteilgehäuse innerhalb eines Volumenvergusses (13) angeordnet sind,
wobei mindestens eines der Halbleiterbauelemente (5) ein Lumineszenzkonversionselement (7) im Strahlengang aufweist, wobei das Lumineszenzkonversionselement (7) die Primärwellenlänge in eine Sekundärwellenlänge zumindest teilweise konvertiert,
wobei das Lumineszenzkonversionselement (7) in einem Volumenverguss (13) mit dem Halbleiterchip (6) des Halbleiterbauelementes (5) gefertigt wird, wobei das Lumineszenzkonversionselement (7) am oberen Rand des Volumenvergusses (13) angeordnet ist,
wobei die Anordnung einen Filter im Strahlengang aufweist, wobei der Filter zwischen Lumineszenzkonversionselement (7) und Halbleiterchip (6) angeordnet ist,
wobei der Filter direkt unterhalb des Lumineszenzkonversionselements (7) angeordnet und von dem Halbleiterchip (6) durch den Volumenverguss beabstandet ist,
wobei der Filter für die Primärwellenlänge durchlässig ist und die Sekundärstrahlung reflektiert wird,
wobei das Material des Halbleiterchips derart ausgestaltet wird, dass der Halbleiterchip (6) des Halbleiterbauelements (5), die erzeugte und die an einem Volumenverguss (13) reflektierte Primärwellenlänge minimal absorbiert und maximal reflektiert.

2. Anordnung nach Anspruch 1, wobei ein ein Lumineszenzkonversionselement (7) aufweisendes Halbleiterbauelement (5) eine kurzwellige im unsichtbaren Wellenlängenbereich befindliche Primärwellenlänge erzeugt.

3. Anordnung nach Anspruch 1, wobei ein ein Lumineszenzkonversionselement (7) aufweisendes Halbleiterbauelement (5) eine kurzwellige, im sichtbaren Wellenlängenbereich befindliche Primärwellenlänge erzeugt.

4. Anordnung nach Anspruch 2 oder 3, wobei sich die erzeugte konvertierte Sekundärwellenlänge im sichtbaren Wellenlängenbereich (430nm bis 760 nm) befindet.

5. Anordnung nach Anspruch 1 bis 4 zur Erzeugung einer Weißlichtquelle für Beleuchtungseinrichtungen (1) an Bildwiedergabegeräten.

6. Anordnung nach Anspruch 1, wobei das Lumineszenzkonversionselement (7) Silikate oder Oxinitride, oder andere grün konvertierende Leuchtstoffe, die im Blauen oder Ultravioletten absorbieren für die Konversion beinhaltet.

7. Anordnung nach Anspruch 6, wobei innerhalb des Bauteilgehäuse (8) ein spiegelndes Element (12) ist, was derart in den Strahlengang des Halbleiterchips (6) eingebracht ist, dass die Primärwellenlänge maximal reflektiert und für die Sekundärwellenlänge transparent ist.

8. Anordnung nach Anspruch 7, wobei der Halbleiterchip (6) des Halbleiterbauelements (5), die konvertierte Sekundärwellenlänge minimal absorbiert und maximal reflektiert.

9. Anordnung nach Anspruch 7 oder 8, wobei die Vergussmasse (13) um das Halbleiterbauelement (5) mit dem Konversionselement (7) beschichtet (10) ist.

10. Anordnung nach Anspruch 1, wobei das Lumineszenzkonversionselement (7) in Form einer Beschichtung direkt auf dem Halbleiterchip (6) platziert ist.

11. Anordnung nach Anspruch 1, wobei das Lumineszenzkonversionselement (7) in Form einer Abdeckung (11) eines Bauteilgehäuses (8) des Halbleiterbauelementes (5) eingebracht ist.

12. Verfahren zur Erzeugung von Mischlicht mit einer Anordnung gemäß Anspruch 1.

13. Verfahren nach Anspruch 12, wobei ein ein Lumineszenzkonversionselement aufweisendes Halbleiterbauelement eine kurzwellige im unsichtbaren Wellenlängenbereich befindliche Primärwellenlänge erzeugt.

## Claims

1. An arrangement for generating mixed light (2), wherein at least two semiconductor components (5) emitting electromagnetic radiation in different wavelength ranges are used as the light source,
wherein the semiconductor components (5) each have a semiconductor chip (6), said semiconductor chips being capable of emitting primary wavelengths and being arranged in a component housing within a volume potting (13),
wherein at least one of the semiconductor components (5) comprises a luminescence conversion element (7) in the beam path, wherein the luminescence conversion element (7) at least partially converts the primary wavelength into a secondary wavelength,
wherein the luminescence conversion element (7) is produced in a volume potting (13) with a semiconductor chip (6) of the semiconductor component (5), wherein the luminescence conversion element (7) is arranged at the upper edge of the volume potting (13),
wherein the arrangement comrpises a filter in the beam path, wherein the filter is arranged between the luminescence conversion element (7) and the semiconductor chip (6), wherein the filter is arranged directly below the luminescence conversion element (7) and is spaced apart from the semiconductor chip (6) by the volume potting (13), wherein the filter is permeable to the primary wavelength and the secondary radiation is reflected,
wherein the material of the semiconductor chip is designed in such a way that the semiconductor chip (6) of the semiconductor component (5) minimally absorbs and maximally reflects the primary wavelength generated and reflected at a volume potting (13).

2. The arrangement according to claim 1, wherein a semiconductor component (5) having a luminescence conversion element (7) generates a short-wave primary wavelength in the invisible wavelength range.

3. The arrangement according to claim 1, wherein a semiconductor component (5) having a luminescence conversion element (7) generates a short-wave primary wavelength in the visible wavelength range.

4. The arrangement according to claim 2 or 3, wherein the generated converted secondary wavelength is in the visible wavelength range (430 nm to 760 nm).

5. The arrangement according to claims 1 to 4 for generating a white light source for illumination devices (1) on image reproduction devices.

6. The arrangement according to claim 1, wherein the luminescence conversion element (7) comprises silicates or oxynitrides, or other green-converting phosphors which absorb in the blue or ultraviolet range, for the conversion.

7. The arrangement according to claim 6, wherein a mirror-reflecting element (12) is arranged within the component housing (8), said mirror-reflecting element being introduced into the beam path of the semiconductor chip (6) in such a way that the primary wavelength is maximally reflected and being transparent to the secondary wavelength.

8. The arrangement according to claim 7, wherein the semiconductor chip (6) of the semiconductor component (5) minimally absorbs and maximally reflects the converted secondary wavelength.

9. The arrangement according to claim 7 or 8, wherein the volume potting (13) around the semiconductor component (5) is coated (10) with the conversion element (7).

10. The arrangement according to claim 1, wherein the luminescence conversion element (7) is placed directly on the semiconductor chip (6) in the form of a coating.

11. The arrangement according to claim 1, wherein the luminescence conversion element (7) is introduced in the form of a cover (11) of a component housing (8) of the semiconductor component (5).

12. A method for producing mixed light having an arrangement according to claim 1.

13. The method according to claim 12, wherein a semiconductor component comprising a luminescence conversion element produces a short-wave primary wavelength in the invisible wavelength range.

## Revendications

1. Agencement destiné à générer de la lumière mixte (2), au moins deux dispositifs semi-conducteurs (5) émettant un rayonnement électromagnétique dans différentes plages de longueur d'onde étant utilisés comme source de lumière,
les dispositifs semi-conducteurs (5) présentant respectivement une puce à semi-conducteur (6), lesquelles sont aptes à l'émission de longueur d'onde primaire et sont disposées dans un boîtier de composant à l'intérieur d'un enrobage volumique (13),
au moins un des dispositifs semi-conducteurs (5) présentant un élément de conversion de luminescence (7) dans le trajet du faisceau, l'élément de conversion de luminescence (7) convertissant au moins en partie la longueur d'onde primaire en une longueur d'onde secondaire,
l'élément de conversion de luminescence (7) étant fabriqué dans un enrobage volumique (13) avec la puce à semi-conducteur (6) du dispositif semi-conducteur (5), l'élément de conversion de luminescence (7) étant disposé sur le bord supérieur de l'enrobage volumique (13),
l'agencement présentant un filtre dans le trajet du faisceau, le filtre étant disposé entre l'élément de conversion de luminescence (7) et la puce à semi-conducteur (6),
le filtre étant disposé directement en dessous de l'élément de conversion de luminescence (7) et étant distancé de la puce à semi-conducteur (6) par l'enrobage volumique,
le filtre étant perméable à la longueur d'onde primaire et le rayonnement secondaire étant réfléchi,
la matière de la puce à semi-conducteur (5) étant conçue de manière à ce que la puce à semi-conducteur (6) du dispositif semi-conducteur (5) absorbe de manière minimale la longueur d'onde primaire générée et réfléchie à un enrobage volumique et la réfléchisse de manière maximale.

2. Agencement selon la revendication 1, un dispositif semi-conducteur (5) présentant un élément de conversion de luminescence (7) générant une longueur d'onde primaire à onde courte se trouvant dans la plage de longueur d'onde invisible.

3. Agencement selon la revendication 1, un dispositif semi-conducteur (5) présentant un élément de conversion de luminescence (7) générant une longueur d'onde primaire à onde courte se trouvant dans la plage de longueur d'onde visible.

4. Agencement selon la revendication 2 ou 3, la longueur d'onde secondaire générée convertie se trouvant dans la plage de longueur d'onde visible (430 nm à 760 nm).

5. Agencement selon les revendications 1 à 4, destiné à générer une source de lumière blanche pour des dispositifs d'éclairage (1) sur des appareils de reproduction d'images.

6. Agencement selon la revendication 1, l'élément de conversion de luminescence (7) contenant des silicates ou des oxynitrures, ou d'autres matières luminescentes convertissant en vert, lesquelles absorbent dans le bleu ou l'ultraviolet pour la conversion.

7. Agencement selon la revendication 6, un élément (12) réfléchissant étant à l'intérieur du boîtier (8) du composant, lequel élément est introduit dans le trajet du faisceau de la puce à semi-conducteur (6) de manière à ce que la longueur d'onde primaire soit réfléchie de manière maximale et soit transparente pour la longueur d'onde secondaire.

8. Agencement selon la revendication 7, la puce à semi-conducteur (6) du dispositif semi-conducteur (5) absorbant la longueur d'onde secondaire convertie de manière minimale et la réfléchissant de manière maximale.

9. Agencement selon la revendication 7 ou 8, la masse d'enrobage (13) étant revêtue par l'élément de conversion (7) autour du dispositif semi-conducteur (5).

10. Agencement selon la revendication 1, l'élément de conversion de luminescence (7) étant directement placé sur la puce à semi-conducteur (6) sous forme d'un revêtement.

11. Agencement selon la revendication 1, l'élément de conversion de luminescence (7) étant placé sous forme d'un revêtement (11) d'un boîtier (8) de composant du dispositif semi-conducteur (5).

12. Procédé destiné à générer de la lumière mixte à l'aide d'un agencement selon la revendication 1.

13. Procédé selon la revendication 12, un dispositif semi-conducteur présentant un élément de conversion de luminescence générant une longueur d'onde primaire à onde courte se trouvant dans la plage de longueur d'onde invisible.
